Europäisches Patentamt

(19) **European Patent Office**

**Office européen des brevets**

(11) Numéro de publication: **0 039 642**
**B1**

(12) **FASCICULE DE BREVET EUROPEEN**

(45) Date de publication du fascicule du brevet:
24.10.84

(51) Int. Cl.³: **G 01 R 33/035, H 01 L 39/22**

(21) Numéro de dépôt: **81400697.9**

(22) Date de dépôt: **04.05.81**

(54) Procédé de réglage des paramètres d'un capteur de flux magnétique à effet Josephson.

(30) Priorité: **05.05.80 FR 8009968**

(43) Date de publication de la demande:
**11.11.81 Bulletin 81/45**

(45) Mention de la délivrance du brevet:
**24.10.84 Bulletin 84/43**

(84) Etats contractants désignés:
**DE GB IT NL**

(56) Documents cités:
**US - A - 3 764 905**
**US - A - 4 025 844**

**REVIEW OF SCIENTIFIC INSTRUMENTS, vol. 45, no. 1, janvier 1974, New York, US E. CUKAUSKAS et al.: "Magnetic susceptibility measurements using a superconducting magnetometer", pages 1-6**
**REVIEW OF SCIENTIFIC INSTRUMENTS, vol. 46, no. 4, avril 1975 New York, US D. DURET et al.: "A uhf super-conducting magnetometer utilizing a new thin film sensor", pages 474-480**

(73) Titulaire: **COMMISSARIAT A L'ENERGIE ATOMIQUE Etablissement de Caractère Scientifique Technique et Industriel, B.P. 510, F-75752 Paris Cedex 15 (FR)**

(72) Inventeur: **Pascal, Daniel, 8, Allée des Bathes, F-91400 Orsay (FR)**
Inventeur: **Duret, Denis, 82, rue Mallyand, F-38000 Grenoble (FR)**

(74) Mandataire: **Mongrédien, André et al, c/o BREVATOME 25, rue de Ponthieu, F-75008 Paris (FR)**

## Description

La présente invention concerne un procédé de réglage des paramètres d'un capteur de flux magnétique à effet Josephson. Elle s'applique au réglage d'un capteur de flux magnétique à effet Josephson, de type SQUID («Superconducting Quantum Interference Device», qui correspond à l'appellation française «Dispositif supraconducteur à interférence quantique»). Ce capteur, qui a la forme d'un anneau supraconducteur et qui sera décrit plus loin en détail, est utilisé pour la mesure de flux magnétique. Une application directe est la mesure d'une induction magnétique (biomagnétisme ou géomagnétisme). Ce capteur peut également être utilisé indirectement dans la mesure de tensions et de courants. Dans ce cas, la tension est appliquée à une inductance couplée au SQUID; il est également possible de faire passer le courant à mesurer dans l'inductance, ce qui produit un flux qui est capté par le SQUID. Une autre application indirecte du capteur est la mesure des températures par évaluation du bruit d'origine thermique apparaissant aux bornes d'une résistance.

On sait qu'un capteur magnétique à effet Josephson, de type «SQUID» est constitué par une jonction à effet Josephson présentant un courant critique $I_c$, insérée dans un anneau supraconducteur de self-inductance L; ce capteur est refroidi à très basse température. Son bon fonctionnement implique que le produit $L \times I_c$ soit de l'ordre de grandeur du quantum de flux $\Phi_o = 2.10^{-15}$ Wb. Dans cette relation $\Phi_o = \frac{h}{2e}$, h est la constante de Planck et e la charge de l'électron. Généralement, ces capteurs présentent une inductance L voisine de 0,5 nH et un courant critique de quelques $\mu$A. Un capteur de ce type est décrit dans la revue RSI-volume 46, n° 4, avril 1975, pages 474 à 480.

Il existe cependant un grand nombre de capteurs de type SQUID utilisant une jonction Josephson. Ces capteurs peuvent être classés en deux catégories:

– les SQUIDS massifs, dans lesquels le matériau utilisé est généralement du niobium, l'anneau étant réalisé par le perçage d'un ou plusieurs trous de forme cylindrique ou de forme torique, dans un bloc massif. La jonction de Josephson se présente généralement sous la forme d'un contact à pointe de niobium s'appuyant sur un plateau réalisé dans le bloc massif. Des SQUIDS de ce type sont décrits dans l'article de J.E. Zimmerman, paru dans la revue «Cryogenics», vol. 12, n° 1, février 1972. Les inconvénients de ces capteurs résultent de leur taille; en effet, leur diamètre est souvent supérieur au centimètre. Ces inconvénients résultent également de leur coût de réalisation, car celle-ci nécessite une mécanqiue de précision. Enfin, ils résultent de l'instabilité de la jonction aux cycles thermiques.

– les SQUIDS en couche mince, dans lesquels le matériau utilisé est généralement du niobium, mais peut également être du plomb, de l'étain, des alliages supraconducteurs, ... L'anneau supraconducteur, dans ce cas, est constitué par une couche mince présentant une épaisseur de 1000 Å environ, déposée sous ultravide, sur un support isolant cylindrique ou plan, qui peut être constitué de quartz, mais qui peut être également constitué par un saphir, par du verre, etc. La jonction de Josephson se présente souvent sous la forme d'un micropont de Dayem ou d'un micropont de Notarys; parfois, cette jonction est une jonction tunnel.

La jonction de Dayem est constituée par deux films supraconducteurs de faible épaisseur (550 Å), reliés entre eux par une constriction, ou micropont, de petites dimensions ($l\mu \times l\mu$). La stabilité des SQUIDS à jonction de Dayem est excellente, mais cette jonction est difficile à réaliser. Il est en effet très difficile, actuellement, de réaliser de façon reproductible un micropont présentant de très faibles dimensions par des techniques classiques: photomasquage ou masquage mécanique. Les solutions connues ne permettent pas d'obtenir des microponts présentant des caractéristiques bien définies et notamment des courants critiques Josephson, définis avec une bonne précision.

Le micropont de Notarys, qui est une variante du micropont de Dayem, utilise l'effet de proximité; dans ce cas, on réalise une jonction plus longue ($25\mu$) et plus large ($4\mu$) et on dépose ensuite, perpendiculairement à ce micropont, une bande de matériau non supraconducteur pouvant avoir une longueur assez importante, mais une largeur de $l\mu$. Le dépôt de ce matériau est très difficile à réaliser.

Il résulte de ces observations que les SQUIDS en couches minces qui utilisent des jonctions de type «micropont de Dayem» ou «micropont de Notarys» sont difficiles à réaliser, à reproduire et que leur fabrication entraîne des déchets importants. Des «Squids» de ce type sont décrits notamment dans le brevet US-A-4,025,844 et dans la revue: «Review of Scientific Instruments, vol. 46, N° 4, avril 1975, article de Duret et al., intitulé: a UHF Superconducting Magnetometer Utilizing a new thin film Sensor, pages 474–480»

La technique s'est cependant orientée peu à peu vers la fabrication de capteurs de flux magnétique à effet Josephson (ou SQUID) à couches minces. En effet, les SQUIDS massifs présentent une trop grande instabilité. C'est ainsi qu'il a été possible de mettre au point un procédé d'élaboration de capteurs de flux magnétique à effet Josephson, se déroulant de la manière suivante:

1. on effectue tout d'abord, dans une enceinte à ultravide, un dépôt d'une couche de 1000 Å environ de niobium, sur un barreau de quartz de 2 mm de diamètre et de 20 cm de long environ. Cette couche de niobium est ensuite recouverte d'une couche d'or présentant également une épaisseur de 1000 Å environ.

2. on tronçonne ensuite le barreau de quartz ainsi recouvert en plusieurs morceaux qui sont enduits de résine photosensible. On grave alors, par photolithographie et par attaque chimique chacun des barreaux, de manière à obtenir un micropont sur une génératrice de chaque morceau cylindrique et on pratique une ouverture de la génératrice opposée du morceau considéré. On soude ensuite quatre fils aux bornes du micropont, ce qui permet de tracer ses caractéristiques courant-tension et d'ajuster son courant critique $I_c$. Chaque morceau ainsi obtenu constitue l'ébauche d'un capteur de flux magnétique à effet Josephson; cette ébauche est alors plongée dans un liquide de refroidissement à très basse température, tel que l'hélium liquide par exemple et son courant critique est mesuré. Les microponts ainsi constitués ne présentent pas encore l'effet Josephson. Le courant critique est diminué jusqu'à une valeur comprise entre 5 et 10 μA par un procédé tel que celui qui est décrit dans la demande de brevet n° 73 31061 déposée le 28 août 1973, au nom du même demandeur. Comme décrit dans ce brevet, le courant critique recherché dans la jonction de Josephson, est obtenu en appliquant à cette jonction portée à très basse température, des impulsions de courant dont l'intensité et la durée ont une valeur qui dépend du courant critique de Josephson que l'on désire obtenir.

3. on retire alors de l'enceinte à très basse température le capteur de Josephson dont le courant critique a été ainsi réglé et dont la couche d'or a été ôtée, et on le place de nouveau dans l'enceinte à ultravide, pour le refermer par une autre couche mince de niobium, la génératrice ouverte à l'opposé du micropont; cette deuxième évaporation ne recouvre pas le micropont.

Ce procédé connu a pour principal inconvénient d'être très lent. En effet, le dépôt d'une couche de niobium demande 24 h de pompage dans l'enceinte à ultravide. De plus, la jonction dont le courant critique a été réduit à 10 μA est fragile tant qu'elle n'est pas court-circuitée par la couche supplémentaire de niobium; cette couche protège la jonction contre les champs électriques parasites qui peuvent apparaître à ses bornes. De plus, la selfinductance L, qui intervient dans la relation $L.I_c \simeq \Phi_0$ n'est pas, en réalité celle du capteur définitivement constitué, mais celle du capteur avant le dépôt de la couche supplémentaire de niobium. Il en résulte que la valeur de la self-inductance du capteur définitivement constitué et dont le courant critique a été réglé de la manière indiquée plus haut, n'est connue qu'avec une précision de 50%. Enfin, les capteurs ainsi obtenus présentent des caractéristiques qui évoluent dans le temps. En effet, le second dépôt de niobium n'adhère pas toujours parfaitement à la première couche, à cause de l'oxyde naturel qui peut se former, à cause des pollutions chimiques lors des manipulations, et également à cause de la température du substrat qui est plus basse lors du dépôt de la seconde couche de niobium. Il en résulte que la fabrication de capteurs selon ce procédé, présente des déchets importants et que ces capteurs présentent une certaine disparité de leurs caractéristiques. Toutefois, un autre procédé, décrit dans US-A-4 025 844, permet de fabriquer un capteur de type SQUID ayant une géométrie voisine de celle du capteur précédemment décrit en ne prévoyant qu'une étape de dépôt mince de matériau supraconducteur.

La présente invention a pour but de simplifier le procédé de réglage de capteurs de flux magnétique à effet Josephson, se présentant sous forme de SQUID en couches minces. Elle a également pour but de simplifier le réglage du courant critique $I_c$, sachant que la valeur de la self-inductance L du capteur reste constante et que le produit $L.I_c$ est connu avec une bonne précision.

L'invention vise un procédé de réglage des paramètres d'un capteur de flux magnétique à effet Josephson du type obtenu par la méthode consistnat à déposer une couche mince et uniforme d'un matériau supraconducteur sur un barreau cylindrique isolant, puis à pratiquer une coupure dans la couche de matériau supraconducteur, le long d'une génératrice du barreau et jusqu'à ce barreau, tout en formant une fonction entre deux bords de cette couche dans cette coupure, caractérisé en ce qu'il consiste à soumettre le capteur ainsi élaboré à des impulsions de réglage du courant critique, par induction, et à mesurer, par induction, l'évolution des paramètres du capteur.

D'autres particularités et avantages de l'invention ressortiront mieux de la description qui va suivre, donnée en référence aux dessins annexés dans lesquels:

– la figure 1 représente un capteur de flux magnétique à effet Josephson,

– la figure 2 représente un dispositif qui permet, selon le procédé de l'invention, de régler le courant critique dans le capteur de flux et de mesurer, par induction, l'évolution des paramètres de ce capteur,

– la figure 3 représente un autre dispositif qui permet, selon le procédé de l'invention, de régler le courant critique dans le capteur de flux.

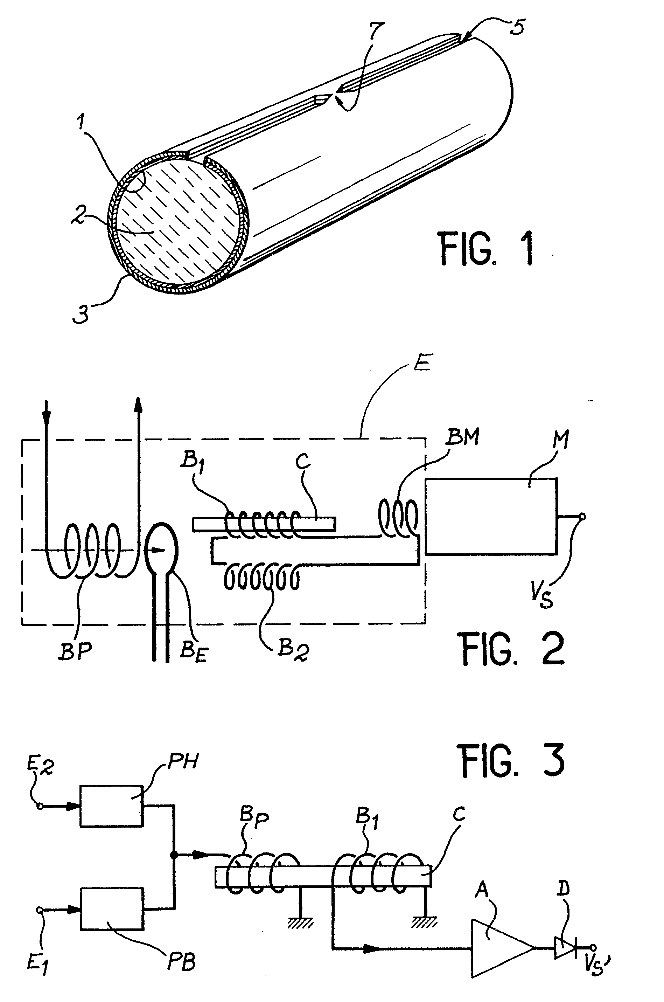

Après avoir été fabriqué le capteur représenté sur la figure 1 est réglé selon le procédé de l'invention. Lors de la fabrication, on dépose une première couche 1, mince et uniforme, d'un matériau supraconducteur tel que le niobium par exemple, sur un barreau 2 cylindrique isolant qui peut être constitué de quartz; on peut éventuellement déposer ensuite une deuxième couche 3, mince et uniforme, d'un matériau conducteur tel que l'or, sur la première couche 1. Ces dépôts sont effectués de manière connue dans une enceinte à ultravide et le barreau de quartz présente un diamètre de 2 mm et une longueur de 20 cm par exemple, tandis que les deux couches de niobium et d'or ont une épaisseur d'environ 1000 Å. Le barreau est assez long pour permettre la formation de plusieurs capteurs, il est découpé en plusieurs morceaux; chacun de ces morceaux est enduit d'une résine photosensible pour permettre, par photolithographie et attaque chimique, de pratiquer une coupure 5, le long d'une génératrice du barreau et jusqu'à ce barreau. Sur cette génératrice, une jonction 7 est maintenu

entre les deux bords de la première et de la deuxième couches; la deuxième couche 3 de matériau conducteur est une couche de protection qui peut permettre des prises de contact électrique. Ces prises de contact ne servent plus pour l'utilisation du capteur, lorsque ses paramètres sont réglés. Après gravure chimique du micropont et de la coupure, la couche 3 est retirée. Le capteur, une fois réglé, est utilisé par induction. Le capteur ainsi réalisé, mais dont le courant critique $I_c$ et les autres paramètres ne sont pas encore définis, est en permanence fermé par la couche supraconductrice 1. Il est alors placé dans un fluide à très basse température, tel que l'hélium liquide par exemple; on mesure $L.I_c/\Phi_o$ et on applique au SQUID des trains d'impulsions qui font diminuer ce rapport. On cesse l'application de ces impulsions lorsque $LI_c/\Phi_o$ est de l'ordre de 1. Ces impulsions qui ont une fréquence située dans la gamme des radiofréquences, lui sont appliquées par induction.

La figure 2 représente le dispositif qui permet de régler le courant critique du capteur par induction, et de mesurer, par induction, l'évolution des paramètres de ce capteur. Sur cette figure, le capteur de la figure 1 est représenté en C. Les impulsions de réglage dont la fréquence est située dans la gamme des radiofréquences sont appliquées au capteur sous la forme de trains successifs d'impulsions; les impulsions de chaque train présentent des amplitudes croissantes et sont appliquées au capteur C, par l'intermédiaire d'une bobine primaire BP qui reçoit ces impulsions. On a représenté par E l'enceinte à basse température (4,2°K par exemple) dans laquelle est située le capteur ainsi que la plupart des éléments du dispositif qui permettent de régler son courant critique et de mesurer ses paramètres caractéristiques. Le capteur est ainsi traversé par un flux d'induction pulsé. Ce flux peut être parfaitement déterminé puisque l'on connaît de façon précise la fréquence et l'amplitude des impulsions qui sont appliquées à la bobine primaire BP ainsi que les caractéristiques de cette bobine primaire. La mesure, par induction, de l'évolution des paramètres du capteur, consiste à placer le capteur dans une bobine secondaire de réglage $B_1$ et à monter en opposition avec cette bobine secondaire $B_1$ qui entoure le capteur C, une bobine secondaire de compensation $B_2$, indentique à la bobine secondaire de réglage. Les bobines secondaires sont reliées à une bobine de mesure BM qui permet de mesurer le gradient de flux entre les deux bobines secondaires $B_1$ et $B_2$. Ce gradient de flux étant dû à la présence du capteur dans la bobine $B_1$. Un magnétomètre M à effet Josephson est associé à la bobine BM et permet de mesurer ce gradient de flux en fonction d'un flux basse fréquence connu, fourni par la bobine BE. Ce magnétomètre délivre une tension $V_s$ proportionnelle au produit de la valeur de la self-inductance L par le courant qui parcourt le capteur. Le produit $LI_c$ est une caractéristique du capteur. On ajuste sa valeur à $\Phi_o = \frac{h}{2e} = 2,07.10^{-15}$ Wb; il en résulte que le magnétomètre M permet de mesurer les principaux paramètres du capteur. Ce magnétomètre est de préférence un magnétomètre à effet Josephson, tel que décrit dans l'article de John CLARKE, paru dans la revue «NATO Advanced Study Institutes Series», Serie B, Physics, Vol. 2-1, 1977, pages 67-124. La bobine primaire reçoit des trains d'impulsions à une fréquence de 450 MHz environ, d'amplitude croissante. Ces trains d'impulsions sont appliqués, par induction, au capteur C; chaque train dure environ 1 microseconde et se répète quatre fois par seconde, avec une amplitude croissante, de sorte que la puissance électromagnétique présente un maximum de 8 watts. On constate alors que le courant critique dans la jonction 7 diminue; l'application des impulsions à la bobine primaire BP cesse lorsque la valeur désirée du produit $LI_c$ et donc la valeur désirée du courant critique $I_c$ est atteinte. La valeur du produit $LI_c$ peut être connue, d'une part par la tension de sortie $V_s$ du magnétomètre et, d'autre part, par le flux $\Phi_a$ d'introduction dans la bobine primaire BP.

La figure 3 représente un autre dispositif qui permet, selon le procédé de l'invention, de régler le courant critique dans le capteur de flux C et de mesurer d'une autre manière l'évolution de ses paramètres.

Cet autre dispositif représente une simplification pratique du précédent, mais ne permet pas d'accéder directement au paramètre $LI_c$.

Le capteur de la figure 1 est représenté en C. Les impulsions de réglage sont appliquées de la même manière que précédemment par la bobine primaire BP dans laquelle est situé le capteur.

La mesure par induction de l'évolution des paramètres du capteur consiste à placer celui-ci dans une autre bobine $B_1$, couplée à un amplificateur A à grand gain (20 MHz), suivi d'un détecteur D. La tension détectée est $V_s$, le capteur est par ailleurs excité à 20 MHz par un oscillateur et par l'intermédiaire de la bobine BP. Cet oscillateur n'est par représenté, il est relié à l'entrée $E_1$ d'un filtre passe-bas PB, dont la sortie est reliée à la bobine BP. Le rapport entre la tension $V_s$, et la tension de sortie de l'oscillateur est liée par une courbe monotone au courant critique du capteur. La connaissance de cette courbe permet de connaître la valeur du courant critique (mais pas la valeur du produit $LI_c$, qui suppose la connaissance préalable de la valeur de la self-inductance du capteur).

Il suffit que la fréquence de l'oscillateur soit inférieure à celle des impulsions de réglage (150 MHz) envoyées dans la bobine BP, par l'intermédiaire d'un filtre passe-haut PH, qui reçoit ces impulsions sur son entrée $E_2$.

Le procédé de réglage qui vient d'être décrit est plus simple et plus rapide que les procédés connus. Il permet de régler la valeur du courant critique $I_c$ avec une grande précision en ajustant le rapport $LI_c/\Phi_o$. L'adhérence du niobium sur le substrat de quartz est parfaite et aucune couche supplémentaire de niobium n'est déposée. Tous les capteurs ainsi réglés le sont au maximum de leurs performances, quel que soit le degré de connaissance de la valeur de la self-inductance L. Le taux de déchets est très faible (inférieur à 10%) et il est dû essentiellement aux incidents qui peuvent survenir lors de la gravure chimique de la coupure.

L'originalité du procédé de l'invention provient du fait qu'on ajuste le courant critique non pas de la jonction seule, mais celui du capteur entier constitué par la jonction et par l'anneau supraconducteur auquel cette jonction est reliée. Selon une variante de réalisation le capteur ne reçoit pas une impulsion de courant, mais un train d'ondes radiofréquence. La durée de ce train peut être très brève et un avantage inhérent au procédé selon l'invention est que le capteur reste en permanence dans l'hélium, alors que dans l'état de la technique, le capteur était retiré de l'hélium liquide, puis replongé dans celui-ci au cours de son élaboration et de son réglage. La valeur du produit $LI_c$ est mesurée grâce à l'utilisation d'un transformateur différentiel constitué par les deux bobines secondaires $B_1$, $B_2$.

Dans l'invention, les impulsions qui présentent une fréquence élevée permettent d'induire le courant nécessaire pour le réglage du capteur, malgré sa très faible inductance (0,5 nH). A la fréquence de 450 MHz par exemple, la puissance appliquée au capteur est de l'ordre de 8 watts. Cette fréquence peut bien entendu varier entre 10 MHz et 1 GHz.

On aurait pu croire que le fait d'appliquer à la jonction, par induction, des impulsions présentant des polarités périodiquement opposées, pouvait être sans effet sur la jonction. En effet, on pouvait craindre que les défauts et le réarrangement cristallin créés dans la jonction pour une première polarité des impulsions ne soient éliminés par les impulsions d'une deuxième polarité opposée à la première polarité l'expérience prouve qu'il n'en est rien.

## Revendications

1. Procédé de réglage des paramètres d'un capteur de flux magnétique à effet Josephson, du type obtenu par la méthode consistant à déposer une couche (1) mince et uniforme d'un matériau supraconducteur sur un barreau cylindrique isolant (2), puis à pratiquer une coupure (5) dans la couche de matériau supraconducteur le long d'une génératrice du barreau et jusqu'à ce barreau, tout en formant une jonction (7) entre deux bords de cette couche dans cette coupure, caractérisé en ce qu'il consiste à soumettre le capteur ainsi élaboré à des impulsions de réglage du courant critique, par induction, et à mesurer, par induction l'évolution des paramètres du capteur.

2. Procédé selon la revendication 1, caractérisé en ce que les impulsions de réglage sont appliquées au capteur par l'intermédiaire d'une bobine primaire (BP) qui reçoit ces impulsions.

3. Procédé selon la revendication 2, caractérisé en ce que la mesure, par induction, de l'évolution des paramètres du capteur est réalisée par l'intermédiaire d'une bobine secondaire de réglage ($B_1$) qui entoure le capteur.

4. Procédé selon la revendication 3, caractérisé en ce que la mesure par induction consiste en outre à monter en opposition avec la bobine secondaire de réglage ($B_1$) qui entoure le capteur, une bobine secondaire de compensation ($B_2$) identique à la bobine secondaire de réglage, ces deux bobines secondaires étant reliées à une bobine de mesure (BM) du gradient de flux entre ces deux bobines secondaires.

5. Procédé selon la revendication 4, caractérisé en ce qu'on associe un magnétomètre (M) à la bobine de mesure (BM) du gradient de flux.

6. Procédé selon la revendication 3, caractérisé en ce que pour la mesure du produit $LI_c$, L représentant la self-inductance et $I_c$ le courant critique du capteur, on soumet le capteur à un flux magnétique à très basse fréquence.

7. Procédé selon la revendication 2, caractérisé en ce que les impulsions de réglage par induction sont des impulsions dont la fréquence est située dans la gamme des radiofréquences.

8. Procédé selon la revendication 7, caractérisé en ce que les impulsions sont appliquées au capteur sous la forme de trains successifs d'impulsions, les impulsions de chaque train présentant des amplitudes croissantes.

9. Procédé selon la revendication 5, caractérisé en ce que le magnétomètre (M) que l'on associe à la bobine de mesure est un magnétomètre à effet Josephson.

10. Procédé selon la revendication 3, caractérisé en ce que pour régler le courant critique et mesurer l'évolution des paramètres du capteur, on applique à la bobine primaire BP, une onde électrique à fréquence plus basse que celle des impulsions de réglage, puis on amplifie le signal de sortie de la bobine $B_1$ à la fréquence de ladite onde électrique et on mesure les variations d'amplitude du signal amplifié à la fréquence de l'onde électrique.

11. Procédé selon l'une quelconque des revendications caractérisé en ce qu'une couche mince et uniforme (3) d'un matériau conducteur déposée sur la couche (1) de matériau supraconducteur permet la formation de prises de contacts électriques de réglage, la coupure (5) étant aussi pratiquée dans cette couche, de manière à réaliser ladite jonction (7).

12. Procédé selon la revendication 11, caractérisé en ce que le matériau supraconducteur est du niobium et en ce que le matériau conducteur est de l'or.

## Claims

1. Process for controlling the parameters of a Josephson effect magnetic flux detector of the type obtained by a method comprising depositing a thin uniform layer (1) of a superconductive material on an insulating cylindrical bar (2), then forming a slit (5) in the layer of superconductive material extending along a generatrix of the bar and down to the bar and forming a junction (7) between two edges of said layer in said slit, characterized in that it comprises subjecting the thereby-formed detector to critical current-controlling pulses by induction, and measuring by induction the evolution of the detector parameters.

2. Process according to Claim 1, characterized in that the control pulses are applied to the detector by means of a primary coil (BP) receiving the pulses.

3. Process according to Claim 2, characterized in that the measurement by induction of the evolution of the detector parameters is realised by means of a secondary control coil ($B_1$) surrounding the detector.

4. Process according to Claim 3, characterized in that the measurement by induction additionally comprises mounting, in opposition to the secondary control coil ($B_1$) surrounding the detector, a secondary compensating coil ($B_2$) identical to the secondary control coil, said two secondary coils being connected to a measuring coil (BM) for measuring the flux gradient between the two secondary coils.

5. Process according to Claim 4, characterized in that a magnetometer (M) is connected to the flux gradient measuring coil (BM).

6. Process according to Claim 3, characterized in that the detector is subjected to a magnetic flux of very low frequency to measure the product $LI_c$, wherein L represents the self-inductance and $I_c$ the critical current of the detector.

7. Process according to Claim 2, characterized in that the induced control pulses are pulses whose frequency lies in the radiofrequency range.

8. Process according to Claim 7, characterized in that the pulses are applied to the detector in the form of successive pulse trains, the pulses of each train having increasing amplitudes.

9. Process according to Claim 5, characterized in that the magnetometer (M) connected to the measuring coil is a Josephson effect magnetometer.

10. Process according to Claim 3, characterized in that control of the critical current and measurement of the evolution of the detector parameters is achieved by applying to the primary coil (BP) an electrical wave whose frequency is lower than that of the control pulses, amplifying the output signal of the coil ($B_1$) at the frequency of said electrical wave, and measuring variations in the amplitude of the amplified signal at the frequency of the electrical wave.

11. Process according to any one of the preceding Claims, characterized in that deposition of a thin uniform layer (3) of a conductive material on the layer (1) of superconductive material enables the formation of electrical contacts for control, the slit (5) being also formed in that layer, whereby to provide said junction₇.

12. Process according to Claim 11, characterized in that the superconductive material is niobium and the conductive material is gold.

**Patentansprüche**

1. Verfahren zur Einstellung der Parameter eines Josephson Effekt-Magnetflussdetektors, bei dem eine dünne und gleichförmige Schicht (1) aus einem supraleitenden Material auf einen zylinderförmigen, isolierenden Stab (2) aufgebracht und daraufhin ein Schnitt (5) in der supraleitenden Materialschicht längs einer Erzeugenden des Stabes und bis zu diesem Stab vorgenommen wird, wobei eine Verbindung (7) zwischen den zwei Rändern dieser Schicht in diesem Schnitt gebildet wird, dadurch gekennzeichnet, dass der derart hergestellte Detektor durch Induktion Impulsen zum Einstellen des kritischen Stromes ausgesetzt wird und dass durch Induktion der Verlauf der Parameter des Detektors gemessen wird.

2. Verfahren nach Anspruch 1, dadurch gekennzeichnet, dass die Impulse zum Einstellen auf den Detektor mittels einer Primärspule (BP) angewandt werden, welche diese Impulse erhält.

3. Verfahren nach Anspruch 2, dadurch gekennzeichnet, dass die induktive Messung des Verlaufes der Parameter des Detektors mittels einer Sekundärspule ($B_1$) zum Einstellen durchgeführt wird, welche den Detektor umgibt.

4. Verfahren nach Anspruch 3, dadurch gekennzeichnet, dass die induktive Messung darin besteht, dass ferner der Sekundärspule ($B_1$), welche den Detektor umgibt, gegenüberliegend eine Sekundärspule ($B_2$) zur Kompensation angeordnet wird, die der Sekundärspule zum Einstellen identisch ist, und dass diese zwei Sekundärspulen mit einer Messspule (BM) für den Gradienten des Flusses zwischen diesen zwei Sekundärspulen verbunden sind.

5. Verfahren nach Anspruch 4, dadurch gekennzeichnet, dass ein Magnetometer (M) der Messspule (BM) für den Flussgradienten zugeordnet ist.

6. Verfahren nach Anspruch 3, dadurch gekennzeichnet, dass zum Messen des Produktes $LE_c$, wobei L die Selbstinduktivität und $E_c$ der kritische Strom des Detektors bedeuten, der Detektor einem magnetischen Fluss mit sehr niederer Frequenz ausgesetzt wird.

7. Verfahren nach Anspruch 2, dadurch gekennzeichnet, dass die Impulse zum Einstellen durch Induktion Impulse sind, deren Frequenz im HF-Bereich liegt.

8. Verfahren nach Anspruch 7, dadurch gekennzeichnet, dass die Impulse an den Detektor in der Form von aufeinander folgenden Impulszügen angewendet werden, wobei die Impulse eines jeden Zuges zunehmende Amplituden aufweisen.

9. Verfahren nach Anspruch 5, dadurch gekennzeichnet, dass das Magnetometer (M), welches man der Messspule zuordnet, ein Josephson Effekt-Magnetometer ist.

10. Verfahren nach Anspruch 3, dadurch gekennzeichnet, dass, um den kritischen Strom einzustellen und den Verlauf der Parameter des Detektors zu messen, an die Primärspule (BP) eine elektrische Welle mit einer niedereren Frequenz als derjenige der Impulse zum Einstellen gelegt wird, woraufhin das Ausgangssignal der Spule ($B_1$) bei der Frequenz der genannten elektrischen Welle verstärkt und die Amplitudenänderungen des verstärkten Signals bei der Frequenz der elektrischen Welle gemessen wird.

11. Verfahren nach irgendeinem der vorhergehenden Ansprüche, dadurch gekennzeichnet, dass eine dünne und gleichförmige Schicht (3), die aus einem leitenden Material besteht, die auf die Schicht (1) aus supraleitendem Material aufgebracht ist, die Ausbildung der elektrischen Abnahmekontakte zum Einstellen erlaubt, wobei der Schnitt (5) auch in dieser Schicht derart vorgenommen wird, dass die Verbindung (7) entsteht.

12. Verfahren nach Anspruch 11, dadurch gekennzeichnet, dass das supraleitende Material aus Niobium und das leitende Material aus Gold besteht.

FIG. 1

FIG. 2

FIG. 3